# EUROPÄISCHE PATENTSCHRIFT

(11) **EP 0 563 736 B1**
(45) Veröffentlichungstag und Bekanntmachung des Hinweises auf die Patenterteilung: **05.08.1998**
(21) Anmeldenummer: 93104669.2
(22) Anmeldetag: 22.03.1993
(51) Int. Cl.: C21D 1/09, C21D 9/56, B23K 9/013

(54) **Verfahren und Vorrichtung zur kontinuierlichen Oberflächenbehandlung stabförmiger langgestreckter Materialien mit metallischer Oberfläche**
Process and apparatus for the continuous surface treatment of wire rods with metallic surface
Procédé et appareillage pour le traitement en continu de la surface de tiges et de barres à surface métallique

(30) Priorität: 31.03.1992 DE 4211167
(43) Veröffentlichungstag der Anmeldung: 06.10.1993
(73) Patentinhaber: Herborn & Breitenbach GmbH, 09112 Chemnitz (DE)
(72) Erfinder: Müller, Volker, Dr., O-6800 Saalfeld (DE); Fehn, Manfred, Dr., O-6800 Saalfeld (DE)
(74) Vertreter: Horn, Klaus, Dr.

(56) Entgegenhaltungen:
- DE-A- 1 427 372
- DE-A- 1 919 052
- FR-A- 1 429 727
- GB-A- 1 332 981
- GB-A- 2 085 330

## Beschreibung

Die Erfindung bezieht sich auf ein Verfahren und eine Vorrichtung zur Oberflächenbehandlung stabförmiger langgestreckter Materialien mit metallischer Oberfläche mittels eines Lichtbogens, der im ersten Teil der Patentansprüche 1 (Verfahren) und 8 (Vorrichtung) angegebenen Gattungen.

Stahl ist nach wie vor weltweit der dominierende Werkstoff, da er universell einsetzbar und umweltfreundlich ist. Bei seiner Verwendung ist die Problematik, Beseitigung der Korrosion und Minimierung der damit verbundenen wirtschaftlichen Verluste, geblieben. Besondere Aufmerksamkeit muß diesem Problem in der Bau- und Drahtseilindustrie gewidmet werden, weil hier besonders hohe Anforderungen an die Korrosionsbeständigkeit auch nach langen Betriebszeiten erfüllt werden müssen. Verzinkte oder kunststoffbeschichtete Stahldrähte erfüllen die Anforderungen hinsichtlich sicherem Korrosionsschutz oft nicht. Massive Edelstahldrähte sind für viele Anwendungen zu teuer bzw. werden den Forderungen hinsichtlich Festigkeit und Alterungsbeständigkeit nicht gerecht.

Aus Gründen eines verbesserten Korrosionsschutzes wird insbesondere Bandmaterial durch Plattieren mit nicht korrodierenden Stoffen beschichtet.

DE-A-1 919 052 offenbart eine Vorrichtung zum Erwarmen eines Werkstückes in Form eines Drahtes oder Rohres mittels eines Lichtbogens, der zwischen dem Werkstück und einer dieses umgebenden Ringelektrode brennt. Der Lichtbogen wird durch das großenveranderlich steuerbare Magnetfeld einer Magnetspule zur Rotation gebracht, wobei die Magnetspule die Ringelektrode über deren Längserstreckung hinausreichend umgibt.

In der US-A-3 211 886 ist eine Bogenreinigungs- und Plasmagenerierungsvorrichtung beschrieben, die eine ringförmige Anode enthält, durch die ein zu bearbeitender Metallstrang geführt wird. Diese Anode ist auf halber Länge zur Ableitung eines von beiden Seiten längs des Drahtes zugeführten Schutzgases geteilt. Die Anodenhälften sind elektrisch miteinander verbunden. Die beiden Gasströme bilden am Eingang des Ausströmkanals in der Anode eine ringförmige Ruhezone, in der ein Lichtbogen brennen kann. Die Rotation des Lichtbogens wird durch eine zweigeteilte Magnetspule verursacht, deren eine Hälfte vor und deren andere Hälfte hinter der Ringanode angeordnet ist. Beide Spulenhälften und die Anode sind elektrisch in Reihe geschaltet, weshalb die Spulenwicklungen aus wassergekühltem Kupferrohr bestehen.
Der Lichtbogen rotiert zwischen der ringförmigen Anode und dem durch diese hindurchgeführten elektrisch leitfähigen Stab. Die beiden entgegengesetzt in die Anode hineingeführten Gasströme sollen verhindern, daß der Lichtbogen durch Mitnahmeeffekte am bewegten Stab den Anodenbereich verläßt. Nachteilig ist, daß die Magnetspule und die Anode in Reihe geschaltet sind und dadurch keine unabhängige Regelung des Magnet- und Anodenstromes erfolgen kann.
Aus der DE-AS 12 62 195 ist eine Vorrichtung zum Befreien einer Metallfläche von Zunder und anderen Verunreinigungen durch periodische Wärmeeinwirkung und mechanische Behandlung mit einem angetriebenen, aus Lamellen aufgebauten, trommelförmigen Werkzeug bekannt. Die bekannte Vorrichtung umfaßt eine Vielzahl kreisringförmiger Lamellen mit radialem Spiel und mit gegenseitigem Abstand, die auf einem von einer Scheibe getragenen Kranz von Tragbolzen gleichmäßig verteilt und radial verschiebbar angeordnet sind, wobei dieses trommelförmige Werkzeug und die Metallfläche an die Pole einer Stromquelle angeschlossen sind, um zwischen dem Werkzeug und der Metallfläche einen Lichtbogen zu erzeugen. Diese bekannte Vorrichtung ist jedoch lediglich zur Bearbeitung von großflächigen Werkstücken geeignet, wie beispielsweise zur Bearbeitung der Oberfläche von Blechen, während langgestreckte Werkstücke, wie beispielsweise Drähte, Rohre oder Bänder, mit Hilfe dieser Vorrichtung nicht bearbeitet bzw. von Verunreinigungen befreit werden können.

Die DE-B-31 10 121 beschreibt eine Einrichtung zur Lichtbogenbearbeitung eines schmalen Metallbands, das in einer Vakuumkammer mit einem expandierten Lichtbogen gleichzeitig auf der Ober- und Unterseite bearbeitet. Das Band wird in der Kammer über eine Umlenkrolle geführt, so daß das die Kammer verlassende Trum neben dem einlaufenden Trum unter der Elektrode hindurchläuft. Diese Einrichtung ist zur Behandlung rotationssymmetrischer Werkstücke nicht geeignet.

Aus der DE-B-30 41 095 ist eine Lichtbogeneinrichtung zur Oberflächenbearbeitung von langen Werkstücken bekannt, in der mit zwei Lichtbögen gearbeitet wird und Werkstückoberseite und die Werkstückunterseite durch je einen Lichtbogen behandelt werden.

Die DE-PS 30 41 119 beschreibt eine Vorrichtung zur Bearbeitung von langen Werkstücken mittels Lichtbogenentladung, bei der mittels zweier nicht rotierender Lichtbögen ein Werkstück innerhalb einer Vakuumkammer auf Ober- und Unterseite behandelt wird. Auch die beiden letztgenannten Vorrichtungen sind nur zur Oberflächenreinigung von flachem, bandförmigem Material geeignet.

Aufgabe der Erfindung ist es, ein Verfahren zur vorzugsweise thermischen Oberflächenbehandlung von stab- bzw. strangförmigen Materialien mit elektrisch leitender Oberfläche aufzuzeigen, mit dem die Nachteile des Standes der Technik überwunden werden und ein feinfühlig steuerbarer gleichmäßiger Energieeintrag über die gesamte Materialoberfläche erreicht wird. Ferner soll eine geeignete Vorrichtung geschaffen werden, die nach dem erfindungsgemäßen Verfahren betrieben werden kann.

Diese Aufgabe wird durch die in den Ansprüchen 1 (Verfahren) bzw. 8 (Vorrichtung) angegebenen Merkmale gelöst.

Gemäß der Erfindung wird der zwischen der den Strang konzentrisch umgebenden Ringelektrode und der Strangoberfläche erzeugte Lichtbogen von dem Magnetfeld in eine Umlauf- bzw. Rotationsbewegung um den Strang versetzt. Durch die Anordnung der Magnetspule in einem geeigneten axialen Abstand hinter der Ringelektrode wird zusätzlich zu dem Rotationseffekt des Lichtbogens durch den sich fächerartig aufspreizenden Verlauf der Feldlinien eine Kraft auf den Lichtbogen, insbesondere auf dessen Fußpunkt auf der Strangoberfläche, ausgeübt, die der Durchlaufrichtung des Stranges entgegengerichtet ist und damit dem unerwünschten Mitnahmeeffekt entgegenwirkt. Die erfindungsgemäße Aufteilung des Lichtbogenstroms auf zwei dem Strang vor und hinter der Ringelektrode über Gleitkontakte zugeführte Teilströme ermöglicht eine einfache und effektive Steuerung des Lichtbogenstroms und ergibt eine geringere thermische Belastung des Stranges. Im Ergebnis der erfindungsgemäßen Maßnahmen wird ein stabiler dauerhafter Lichtbogen erreicht, der mit beeinflußbarer, gleichmäßiger Geschwindigkeit um den Strang rotiert und einen gleichförmigen Wärmeeintrag in die oberflächennahen Schichten des Strangmaterials ohne lokale Überhitzungen gewährleistet. Durch gegenseitige Abstimmung z. B. der Durchlaufgeschwindigkeit des Stranges bzw. des Stabmaterials, des axialen Abstands zwischen der Ringelektrode und der Magnetspule, der Größe und Art der Erregerströme für das Magnetfeld und den Lichtbogen kann der Wärmeeintrag in das Stranggutmaterial gesteuert und beispielsweise auf die oberflächennahen Wandbereiche beschränkt werden. Damit ermöglicht die Erfindung eine effektive thermische Abtrennung von Oberflächenbelägen und Anbackungen, d. h. eine wirksame Reinigung der Strangoberfläche. Ferner kann die Außenschicht von aus unterschiedlichen Materialschichten aufgebauten Verbundsträngen gezielt erwärmt werden, was beispielsweise beim mehrstufigen Ziehen derartiger Verbundstränge von Vorteil ist, wenn nur das Material der Außenschicht weichgeglüht oder auch oberflächengehärtet werden soll.

Die gewünschte Lagestabilität des rotierenden Lichtbogens kann weiterhin durch die Verwendung eines gepulsten Lichtbogenstroms verbessert werden, weil dadurch die Haftung des Lichtbogenfußpunktes auf einer Stelle der durchlaufenden Strangoberfläche und damit der Mitnahmeeffekt vermindert werden und sich zusätzliche Steuermöglichkeiten eröffnen. Ähnlich vorteilhafte Wirkungen ergeben sich durch eine Impulsüberlagerung mindestens eines der beiden elektrischen Teilströme.

Je nach den Materialeigenschaften des zu behandelnden Stranggutes kann es zweckmäßig sein, einen Schutzgasstrom gegen die Lichtbogen und auf den erwärmten Strangabschnitt zu leiten, der eine zusätzliche Lage stabilisierung des rotierenden Lichtbogens und gleichzeitig eine gezielte Oberflächenkühlung des Stranges bewirkt.

Die thermische Oberflächenbehandlung nach dem erfindungsgemäßen Verfahren und mittels der erfindungsgemäßen Vorrichtung kann einerseits als Zwischenglühen von edelstahlplattiertem Draht im Verlauf von Ziehumformungen durchgeführt werden, wobei nur der Mantelwerkstoff thermisch beeinflußt wird. Andererseits kann sie auch zum Anlassen von hochfestem Stahldraht zur Vermeidung von Spannungsrißbildung oder zur Beseitigung adhäsiv gebundener Oberflächenschichten auf metallischen Stäben angewendet werden.

Die Erfindung bietet folgende Vorteile. Der Wärme eintrag erfolgt mit sehr hohem Wärmeübergangskoeffizienten direkt durch die Oberfläche des zu behandelnden Werkstücks. Der Wärmeeintrag geschieht gleichmäßig, konzentrisch und ist relativ unempfindlich gegen Lageabweichungen des zu behandelnden Werkstücks innerhalb der Ringanode. Das Verfahren weist einen hohen thermischen Wirkungsgrad auf. Parameter, wie Wärmemenge, Eindringtiefe der Wärmewirkung, Abkühlungsgeschwindigkeit und Schutzgasstrom, sind problemlos einstellbar. Da sich ferner der Lichtbogenstrom aus mehreren unabhängig voneinander einstellbaren Teilströmen (Gleichstrom) zusammensetzt, kann eine auf den Fußpunkt des Lichtbogens ausgeübte Kraftwirkung mit einfachen technischen Mitteln gesteuert werden. Der in Stablaufrichtung hinter der Ringelektrode angeordnete, für die Lichtbogenrotation verantwortliche Gleichstrommagnet bewirkt eine dem Mitnahmeeffekt entgegengerichtete Kraft auf den Lichtbogen, wobei der Abstand zwischen der Ringelektrode und dem Elektromagneten nach betrieblichen Kriterien gewählt bzw. eingestellt wird. Ein gepulster Lichtbogenstrom erleichtert die Relativverschiebung des Lichtbogens auf der Strangoberfläche und unterstützt so dessen gleichmäßige Rotation. Der Erregerstrom des Magneten und der Lichtbogenstrom sollten unabhängig voneinander eingestellt werden können. Schließlich erzeugt die besondere Zuführung eines Schutzgasstromes neben einer intensivierten Kühlung des Stranggutes eine Kraft auf den Lichtbogen, die den Mitnahmeeffekt reduziert und die vom Lichtbogen abgelösten Oberflächenverschmutzungen des Stranges werden sofort aus der Wärmezone geblasen.

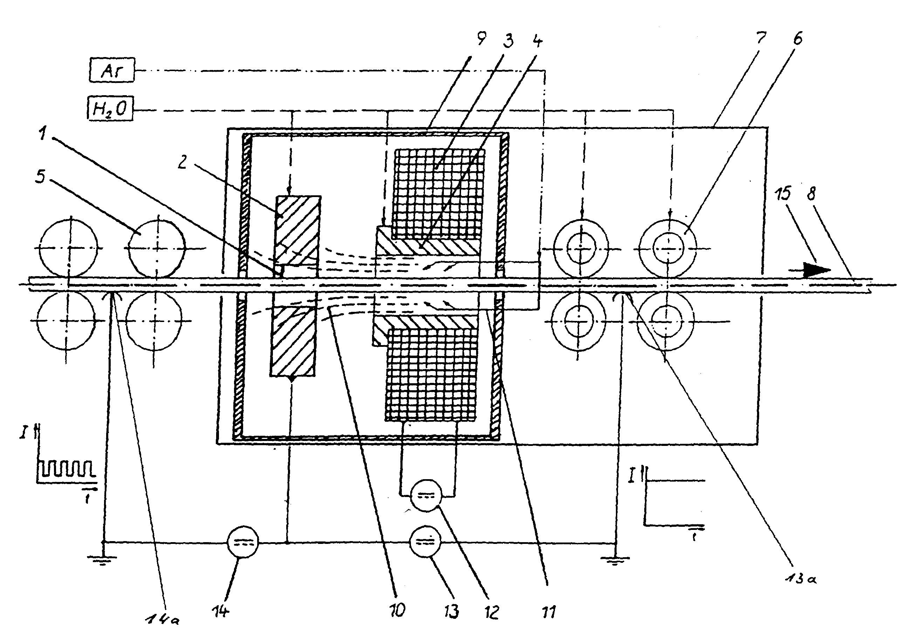

Weitere Besonderheiten und Vorzüge der Erfindung lassen sich der folgenden Beschreibung eines bevorzugten Ausführungsbeispieles anhand der Zeichnung entnehmen, in der eine Vorrichtung zur kontinuierlichen thermischen Oberflächenbehandlung von Stranggut mit metallischer Oberfläche schematisch dargestellt ist.

Bei der dargestellten Vorrichtung wird ein Lichtbogen 1 von zwei unabhängig voneinander einstellbaren Gleichstromquellen 13, 14 gespeist, deren negative Ausgänge mit je einem in Durchlaufrichtung 15 vor und hinter der Ringelektrode 2 angeordneten Gleitkontakt 13a, 14a verbunden sind, über die je ein Teilstrom dem Stab bzw. Strang 8 zugeführt wird. Die Ringelektrode 2 ist mit den positiven Anschlußkontakten beider Stromquellen 13, 14 verbunden, wobei ein Energieeintrag in das Werkstück von 500 bis 2000 J/cm² zum Oberflächenglühen und weniger als 200 J/cm² zum Oberflächenreinigen zu realisieren ist. Die kathodenseitige Aufteilung des den Lichtbogen 1 speisenden Stroms auf die vor und hinter der Ringelektrode 2 befindlichen Anschlußkontakte erfolgt im Verhältnis 1:1,5 bis 1:6, so daß im Ergebnis ein Lichtbogen 1 mit einer Länge von 2 bis 5 mm erzeugt wird.
Die Ringelektrode 2 befindet sich im inhomogenen Magnetfeldbereich außerhalb eines kernlosen hohlzylindrischen Gleichstrommagneten 3, der mit einer Stromquelle 12 (Gleichstromquelle) verbunden und koaxial zur Stabachse angeordnet ist. Der Gleichstrommagnet 3 ist in Durchlaufrichtung 15 in einem vorbestimmten und ggf. einstellbaren Abstand hinter der Ringelektrode 2 angeordnet. Die magnetische Durchflutung des Gleichstrommagneten 3 sollte > 5000 A betragen.
Der Magnetstrom (Gleichstromquelle 12) und Lichtbogenstrom sind unabhängig voneinander einstellbar. Ringelektrode 2 und Gleichstrommagnet 3 befinden sich innerhalb einer zur Stabachse symmetrischen Gehäusekonstruktion aus magnetischem Material 9, die den magnetischen Rückschluß gewährleistet.
In Durchlaufrichtung 15 sind vor und hinter der Ringelektrode 2 Stabführungsrollen 5, 6 angeordnet, die eine Zentrierung des Stabes 8 zur Ringelektrode 2 bewirken. Die hinter der Ringelektrode 2 angeordneten Führungsrollen 6 weisen eine Wasserkühlung auf. Gleiches trifft für die Ringelektrode 2 sowie den Durchlaufbereich 4 des Gleichstrommagneten 3 zu. Die gesamte Vorrichtung befindet sich innerhalb eines mit Schutzgas gefüllten Kastens 7, der Durchführungsöffnungen für den Strang 8 enthält. Die Zufuhr des Schutzgases erfolgt in Strangbewegungsrichtung hinter der Ringelektrode 2 durch Düsen 11, die von mehreren Seiten auf den Strang 8 gerichtet sind.

Am stärksten wirkt sich die Beeinflussung des Lichtbogens 1 durch kathodenseitiges Stromsplitting aus. Ein gegen die Durchlaufrichtung 15 des Stranges 8 zugeführter elektrischer Teilstrom bewirkt eine Kraft in derselben Richtung auf den Fußpunkt des Lichtbogens 1. Ein zweiter, vom ersten unabhängiger elektrischer Teilstrom in Durchlaufrichtung 15 ist erforderlich, um bei konstantem Gesamtbogenstrom (Summe der Teilströme) diese Kraftwirkung ohne Verschiebung des Bogenfußpunktes steuern zu können. Als positiv erweist sich hier außerdem, daß die thermische Belastung des Kernmaterials durch Stromsplitting im Vergleich zur einseitigen Stromeinspeisung reduziert werden kann.

Ein äußeres Magnetfeld, dessen Feldlinien 10 im Bereich der Ringelektrode 2 achsparallel verlaufen, bringt den zwischen Ringelektrode 2 und Strang 8 stehenden Lichtbogen 1 zum Rotieren um den Strang 8. Diese Rotation erzeugt eine Komponente des Lichtbogens 1, die orthogonal auf der von den Magnetfeldlinien 10 und dem idealen, stehenden Lichtbogen 1 aufgespannten Ebene steht (Rotationskomponente). Das äußere Magnetfeld wird von dem kernlosen Gleichstrommagneten 3 erzeugt, dessen Magnetfeldlinien 10 nur im Inneren in Achsnähe achsparallel verlaufen. Verschiebt man die Ringelektrode 2 auf der Achse des Gleichstrommagneten 3 heraus, so sind mit wachsender Entfernung von demselben Magnetfeldanteile festzustellen, die orthogonal auf der Achse des Stranges 8 (Stabachse) stehen (Divergenzkomponente). Die Rotationskomponente des Lichtbogens 1 ergibt in Verbindung mit der Divergenzkomponente des Magnetfeldes eine Kraftwirkung auf den Lichtbogen 1, die - unabhängig von der Richtung des Magnetfeldes - von dem Gleichstrommagnet 3 weg weist.

Um die beschriebene Kraft gegen den Mitnahmeeffekt wirken zu lassen, wurde der Gleichstrommagnet 3 in Stranglaufrichtung hinter der Ringelektrode 2 angeordnet.

Der Schutzgasstrom ist zweckmäßigerweise entgegen der Stranglaufrichtung vorgesehen. Das bewirkt zum einen eine Kraft auf den Lichtbogen 1, die den Mitnahmeeffekt reduziert, zum anderen umströmt so das neu zugeführte, kalte Schutzgas den thermisch behandelten, heißen Strang 8 und trägt zur Kühlung bei. Des weiteren werden vom Lichtbogen 1 abgelöste Oberflächenverschmutzungen des Stranges 8 sofort aus der Wärmezone geblasen.

Die Überlagerung des Bogenstromes mit Impulsen führt zur Ausbildung eines steifen Lichtbogens 1. Des weiteren ist der kathodenseitige Fußpunkt des Lichtbogens 1 leicht auf der Strangoberfläche verschiebbar. Das bewirkt eine relative Unempfindlichkeit gegenüber Oberflächenfehlern auf dem Strang 8. Da die Bogenrotationsfrequenz bei ca. 500 Hz liegt, ist eine Strompulsfrequenz von ca. 5 kHz bei einer Pulshöhe von 15 % des Bogenstromes anzustreben.

## Patentansprüche

1. Verfahren zur kontinuierlichen Behandlung strangförmiger Materialien mit metallischer Oberfläche mittels eines zwischen einer Ringelektrode (2) und dem Strang (8) erzeugten Lichtbogens, wobei
- ein Magnetfeld (10) in Strangdurchlaufrichtung hinter der Ringelektrode (2) erzeugt wird, welches den Lichtbogen (1) in eine Rotation um den Strang (8) versetzt und dem Mitnahmeeffekt des Lichtbogenfußpunktes durch den bewegten Strang (8) entgegenwirkt und
- der Lichtbogenstrom von zwei unabhängig steuerbaren Teilströmen gebildet wird, die der Ringelektrode (2) gemeinsam und dem Strang (8) gesondert vor und hinter der Ringelektrode (2) zugeführt werden.

2. Verfahren nach Anspruch 1,
dadurch gekennzeichnet,
daß der Lichtbogenstrom kathodenseitig als Teilströme im Verhältnis von 1:1,5 bis 1:6 dem Strang (8) vor und hinter der Ringelektrode (2) zugeführt wird.

3. Verfahren nach Anspruch 1 oder 2,
dadurch gekennzeichnet,,
daß ein Schutzgasstrom in den Ringanodenraum und den Magnetfeldraum entgegengesetzt zur Bewegungsrichtung des Stranges eingeführt wird.

4. Verfahren nach einem der Ansprüche 1 bis 3,
dadurch gekennzeichnet,
daß die Ringelektrode (2) und die Oberfläche des behandelten Stranges (8) gekühlt werden.

5. Verfahren nach einem der Ansprüche 1 bis 4,
dadurch gekennzeichnet,
daß zumindest der kleinere Teilstrom mit Impulsen überlagert wird, deren Amplitude bis zu 50 % des Grundstroms beträgt und deren Frequenz zwischen 5 und 10 kHz liegt.

6. Verfahren nach einem der Ansprüche 1 bis 5,
dadurch gekennzeichnet,
daß beide Teilströme des Lichtbogenstroms gepulst werden.

7. Verfahren nach einem der Ansprüche 1 bis 6,
dadurch gekennzeichnet,
daß der Strom zur Erzeugung des Magnetfeldes unabhängig vom Lichtbogenstrom gesteuert wird.

8. Vorrichtung zur thermischen Behandlung von strangförmigem Material mit einer Metalloberfläche, bestehend aus
- einer Ringelektrode (2) zur Erzeugung eines Lichtbogens (1),
- einer der Ringelektrode (2) benachbarten Magnetspule (3) zur Erzeugung einer Umlaufbewegung des Lichtbogens (1) um den Strang (8) und
- Führungselementen (5, 6) zum zentrierten Führen des Strangs (8) durch die Ringelektrode (2) und die Magnetspule (3),
**dadurch gekennzeichnet,** daß
- die Magnetspule (3) in Durchlaufrichtung (15) des Stranges (8) in einem solchen Abstand hinter der Ringelektrode (2) angeordnet ist, daß sich die Ringelektrode (2) im inhomogenen Magnetfeld (10) der Magnetspule (3) befindet, und
- vor und hinter der Ringelektrode (2) je ein Kontakt (14a, 13a) angeordnet ist, über den dem Strang (8) je ein Teilstrom des Lichtbogenstroms zuführbar ist.

9. Vorrichtung nach Anspruch 8,
dadurch gekennzeichnet,
daß jeder Kontakt (13a, 14a) mit je einer steuerbaren Stromquelle (13, 14) verbunden ist, die gemeinsam an die die Anode bildende Ringelektrode (2) angeschlossen sind.

10. Vorrichtung nach Anspruch 8 oder 9,
dadurch gekennzeichnet,
daß in Durchlaufrichtung (15) des Stranges (8) hinter der Magnetspule (3) mit einem Schutzgas beaufschlagte Düsen (11) in gegensinniger Ausrichtung zur Durchlaufrichtung (15) angeordnet sind.

11. Vorrichtung nach einem der Ansprüche 8 bis 10,
dadurch gekennzeichnet,
daß eine gesondert steuerbare Stromversorgung (12) für die Magnetspule (3) vorgesehen ist.

12. Vorrichtung nach einem der Ansprüche 8 bis 10,
dadurch gekennzeichnet,
daß der Lichtbogen-Stromversorgung mindestens ein Impulsgenerator zugeordnet ist.

13. Vorrichtung nach einem der Ansprüche 8 bis 12,
dadurch gekennzeichnet,
daß zumindest die Ringelektrode (2) und die Magnetspule (3) von einem Gehäuse (7) umgeben sind, das Durchlauföffnungen für den Strang (8) aufweist.

14. Vorrichtung nach einem der Ansprüche 8 bis 13,
dadurch gekennzeichnet,
daß die Ringelektrode (2), der Durchlaufbereich (4) der Magnetspule (3) und die hinter der Ringelektrode (2) angeordneten Führungselemente (6) an ein Wasserkühlsystem angeschlossen sind.

## Claims

1. A process for continuously treating materials in the form of an elongate portion having a metallic surface by means of an arc produced between an annular electrode (2) and the elongate portion (8), wherein
- a magnetic field (10) is produced downstream of the annular electrode (2) in the direction of movement of the elongate portion, which magnetic field causes the arc (1) to rotate about the elongate portion (8) and counteracts the entrainment effect of the arc base point by the moving elongate portion (8), and
- the arc current is formed by two independently controllable partial currents which are fed to the annular electrode (2) jointly and to the elongate portion (8) separately upstream and downstream of the annular electrode (2).

2. A process according to claim 1 characterised in that the arc current is fed at the cathode side to the elongate portion (8) upstream and downstream of the annular electrode (2) in the form of partial currents in a ratio of 1:1.5 to 1:6.

3. A process according to claim 1 or claim 2 characterised in that a protective gas flow is introduced into the annular anode space and the magnetic field space in opposite relationship to the direction of movement of the elongate portion.

4. A process according to one of claims 1 to 3 characterised in that the annular electrode (2) and the surface of the treated elongate portion (8) are cooled.

5. A process according to one of claims 1 to 4 characterised in that at least the smaller partial current has superimposed thereon pulses whose amplitude is up to 50% of the basic current and whose frequency is between 5 and 10 kHz.

6. A process according to one of claims 1 to 5 characterised in that both partial currents of the arc current are pulsed.

7. A process according to one of claims 1 to 6 characterised in that the current for producing the magnetic field is controlled independently of the arc current.

8. Apparatus for thermally treating material in the form of an elongate portion having a metal surface, comprising
- an annular electrode (2) for producing an arc (1),
- a magnetic coil (3) adjacent to the annular electrode (2) for producing a circulatory movement of the arc (1) about the elongate portion (8), and
- guide elements (5, 6) for centeredly guiding the elongate portion (8) through the annular electrode (2) and the magnetic coil (3),
characterised in that
- the magnetic coil (1) is arranged at such a spacing downstream of the annular electrode (2) in the direction (15) of movement of the elongate portion (8) that the annular electrode (2) is in the non-homogenous magnetic field (10) of the magnetic coil (3), and
- arranged upstream and downstream of the annular electrode (2) is a respective contact (14a, 13a), by way of which a respective partial current of the arc current can be fed to the elongate portion (8).

9. Apparatus according to claim 8 characterised in that each contact (13a, 14a) is connected to a respective controllable current source (13, 14) which are jointly connected to the annular electrode (2) forming the anode.

10. Apparatus according to claim 8 or claim 9 characterised in that nozzles (11) which are supplied with a protective gas are arranged downstream of the magnetic coil (3) in the direction (15) of movement of the elongate portion (8), with the nozzles being oriented in opposite relationship to the direction (15) of movement of the elongate portion.

11. Apparatus according to one of claims 8 to 10 characterised in that there is provided a separately controllable current supply (12) for the magnetic coil (3).

12. Apparatus according to one of claims 8 to 10 characterised in that at least one pulse generator is associated with the arc current supply.

13. Apparatus according to one of claims 8 to 12 characterised in that at least the annular electrode (2) and the magnetic coil (3) are enclosed by a housing (7) which has openings for the elongate portion (8) to pass therethrough.

14. Apparatus according to one of claims 8 to 13 characterised in that the annular electrode (2), the through-passage region (4) of the magnetic coil (3) and the guide elements (6) which are arranged downstream of the annular electrode (2) are connected to a water cooling system.

## Revendications

1. Procédé de traitement en continu de matériaux filiformes dotés d'une surface métallique, au moyen d'un arc électrique produit entre une électrode annulaire (2) et le produit filiforme (8), dans lequel,
- un champ magnétique (10) est produit, en aval de l'électrode annulaire (2), dans la direction de passage du produit filiforme, lequel champ magnétique met l'arc électrique (1) en rotation autour du produit filiforme (8) et s'oppose à l'effet d'entraînement du pied de l'arc électrique par le produit filiforme (8) en déplacement, et
- le courant d'arc électrique est constitué de deux courants partiels susceptibles d'être commandés de façon indépendante, qui sont amenés en commun à l'électrode annulaire (2) et séparément au produit filiforme (8) en amont et en aval de l'électrode annulaire (2).

2. Procédé selon la revendication 1,
caractérisé en ce que
le courant d'arc électrique est amené, côté cathode, sous forme de courants partiels, dans un rapport compris entre 1/1,5 et 1/6, au produit filiforme (8) en amont et en aval de l'électrode annulaire (2).

3. Procédé selon la revendication 1 ou 2,
caractérisé en ce que
un courant de gaz de protection est introduit dans l'espace d'anode annulaire et dans l'espace du champ magnétique, à contre-courant par rapport à la direction de déplacement du produit filiforme.

4. Procédé selon l'une des revendications 1 à 3,
caractérisé en ce que
l'électrode annulaire (2) et la surface du produit filiforme (8) traité sont refroidies.

5. Procédé selon l'une des revendications 1 à 4,
caractérisé en ce que
des impulsions sont superposées au moins au courant partiel le plus faible, dont l'amplitude atteint jusqu'à 50 % du courant de base et dont la fréquence est comprise entre 5 et 10 kHz.

6. Procédé selon l'une des revendications 1 à 5,
caractérisé en ce que
les deux courants partiels du courant d'arc électrique sont des courants pulsés.

7. Procédé selon l'une des revendications 1 à 6,
caractérisé en ce que
le courant destiné à produire le champ magnétique est commandé indépendamment du courant d'arc électrique.

8. Dispositif de traitement thermique de matériau filiforme comportant une surface métallique, constitué
- d'une électrode annulaire (2) destinée à produire un arc électrique (1),
- d'un solénoïde (3) situé à proximité de l'électrode annulaire (2), destiné à produire un mouvement de rotation de l'arc électrique (1) autour du produit filiforme (8)
- et d'éléments de guidage (5, 6) destinés à guider de façon centrée le produit filiforme (8) dans l'électrode annulaire (2) et dans le solénoïde (3),
caractérisé en ce que
- le solénoïde (3) est disposé en aval de l'électrode annulaire (2), dans la direction de déplacement (15) du produit filiforme (8) avec un écart tel que l'électrode annulaire (2) se trouve dans un champ magnétique (10) non homogène du solénoïde (3),
- et en ce qu'un contact respectif (14a, 13a) est disposé en amont et en aval de l'électrode annulaire (2), par l'intermédiaire duquel un courant partiel de l'arc électrique peut être amené au produit filiforme (8).

9. Dispositif selon la revendication 8,
caractérisé en ce que
chaque contact (13a, 14a) est connecté à une source de courant respective (13, 14) susceptible d'être commandée, lesquelles sources sont raccordées en commun à l'électrode annulaire (2) formant l'anode.

10. Dispositif selon la revendication 8 ou 9,
caractérisé en ce que
des buses (11) soumises à un gaz de protection sont disposées en aval du solénoïde (3), dans la direction de passage (15) du produit filiforme (8), en étant orientées en sens inverse par rapport à la direction de passage (15).

11. Dispositif selon l'une des revendications 8 à 10,
caractérisé en ce que
une alimentation en courant (12), susceptible d'être commandée séparément, est prévue pour le solénoïde (3).

12. Dispositif selon l'une des revendications 8 à 10,
caractérisé en ce que
au moins un générateur d'impulsions est affecté à l'alimentation en courant de l'arc électrique.

13. Dispositif selon l'une des revendications 8 à 12,
caractérisé en ce que
au moins l'électrode annulaire (2) et le solénoïde (3) sont entourés par un caisson (7) qui présente des ouvertures de passage pour le produit filiforme (8).

14. Dispositif selon l'une des revendications 8 à 13,
caractérisé en ce que
l'électrode annulaire (2), la zone de passage (4) du solénoïde (3) et les éléments de guidage (6) disposés en aval de l'électrode annulaire (2) sont raccordés à un système de refroidissement à eau.
